# EUROPEAN PATENT APPLICATION

(11) **EP 2 662 982 A2**
(43) Date of publication of application: **13.11.2013**
(21) Application number: 13165019.4
(22) Date of filing: 23.04.2013
(51) Int. Cl.: H03K 17/96

(54) **Touch device**

(30) Priority: 10.05.2012 CN 201210143454
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Ma, Xiao-Hui, Shenzhen City, Guangdong Province 518109 (CN); Li, Xin-Ping, Shenzhen City, Guangdong Province 518109 (CN)
(74) Representative: Gray, John James

(57) **Abstract**

A touch device (10) includes a touch panel (1), a circuit board (2), and at least one capacitive sensing element (3) located between the touch panel (1) and the circuit board (2). The circuit board (2) includes a top layer (21) and a bottom layer (22), each capacitive sensing element (3) is mounted to the top layer (21), the bottom layer (22) defines at least one first area (221), each first area (221) corresponds to each capacitive sensing element (3), and each first area (221) is not coated with copper.

## Description

### Description of Related Art

Touch devices are widely used in various electronic apparatuses, such as mobile phones, etc. Generally, a capacitive sensing element is incorporated in a touch device, the capacitive sensing element is mounted to a top surface of a circuit board incorporated in a touch device, and a button or key surface of the circuit board is coated with copper. When a user presses or contacts with a label that corresponds to the capacitive sensing element and is formed on a touch surface of the touch device, an amount of electric charge of the capacitive sensing element is changed, and a normal operation is executed.

However, when a user accidently contacts with the copper formed on the button surface or an ESD current flows through the copper formed on the button surface, the amount of electric charge of the capacitive sensing element may be changed, and an error operation may be executed.

Therefore, there is room for improvement in the art.

### Summary

According to an exemplary embodiment of the invention, a touch device includes a touch panel, a circuit board, and at least one capacitive sensing element. The at least one capacitive sensing element is located between the touch panel and the circuit board. The circuit board includes a top layer and a bottom layer, each capacitive sensing element is mounted to the top layer, the bottom layer defines at least one first area, each first area corresponds to each capacitive sensing element, and each first area is not coated with copper. Because each first area is not coated with copper, and each first area corresponds to one of three capacitive sensing elements, error operation is effectively prevented.

### BRIEF DESCRIPTION OF THE DRAWINGS

Many aspects of the embodiments can be better understood with reference to the following drawings. The components in the drawings are not necessarily drawn to scale, the emphasis instead being placed upon clearly illustrating the principles of the present embodiments. Moreover, in the drawings, like reference numerals designate corresponding parts throughout four views.

FIG. 1 is a perspective view showing a touch device in accordance with one embodiment.

FIG. 2 is an exploded view showing the touch device in FIG. 1 viewed from one direction.

FIG. 3 is an exploded view showing the touch device in FIG. 1 viewed from the other direction.

FIG. 4 is a cross-sectional view showing the touch device in FIG. 1 along line IV-IV.

### DETAILED DESCRIPTION

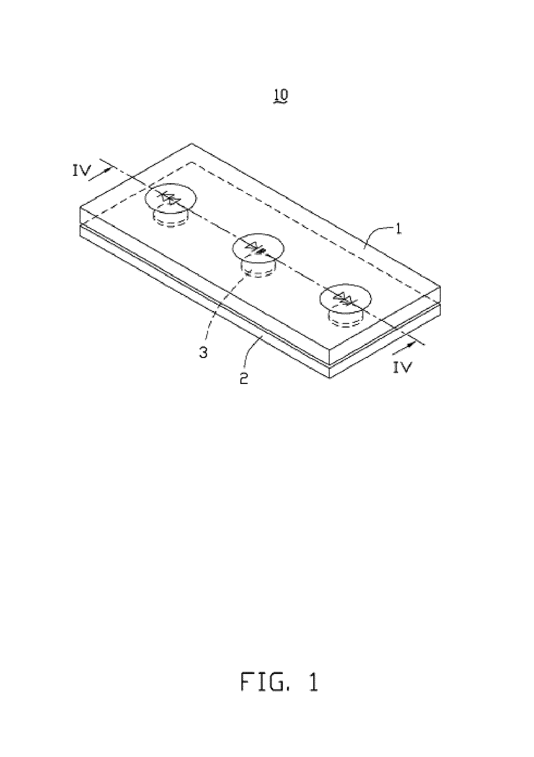

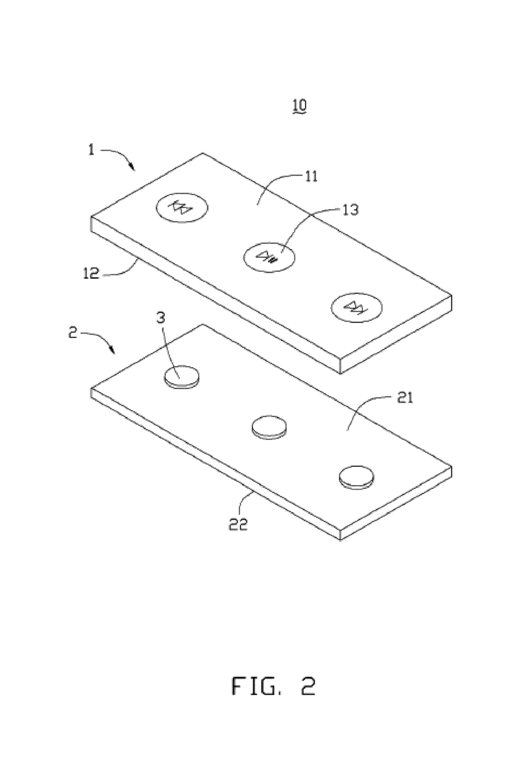

Referring to FIGs. 1 and 2, a touch device 10 includes a touch panel 1, a circuit board 2, and three capacitive sensing elements 3. The circuit board 2 is located below the touch panel 1. Three capacitive sensing elements 3 are located between the touch panel 1 and the circuit board 2.

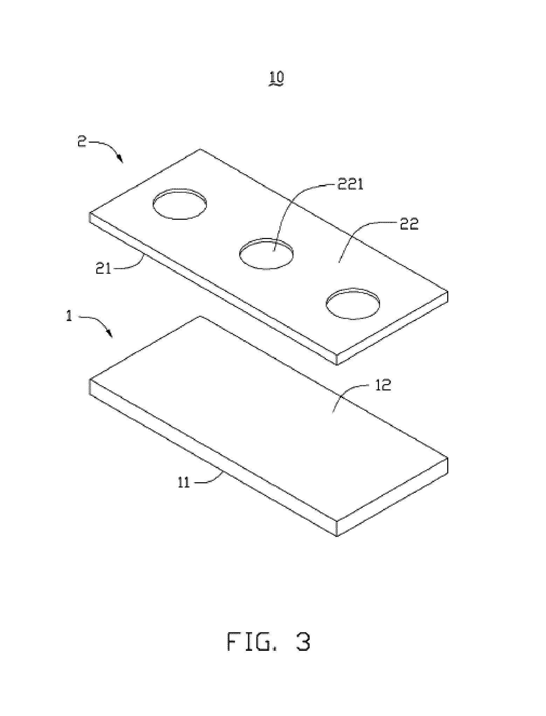

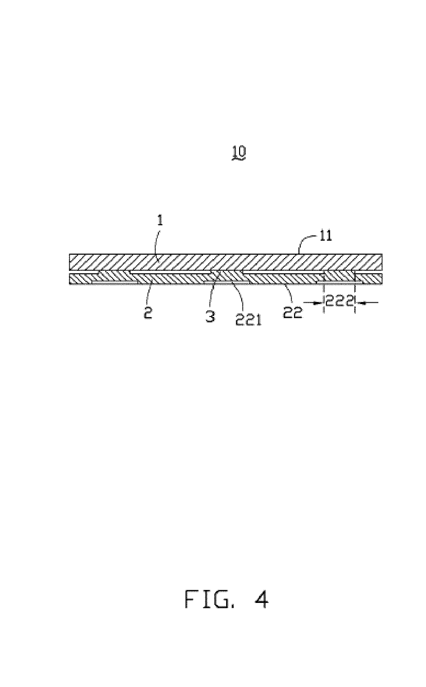

Referring also to FIGs. 3 and 4, the circuit board 2 includes a top layer 21 and a bottom layer 22. Three capacitive sensing elements 3 are mounted to the top layer 21, and the three capacitive sensing elements 3 are arranged along the same line. The bottom layer 22 defines three first areas 221 respectively correspond to three capacitive sensing elements 3, and each of the first areas 221 is not coated with copper. In other embodiments, the bottom layer 22 is not coated with copper. The area of the top layer 21 that is outside of three capacitive sensing element 3 is not coated with copper. In the embodiment, each capacitive sensing element 3 is a copper sheet.

Three second areas 222 are respectively defined by a vertical projection of three capacitive sensing elements 3 onto the bottom layer 22, the dimension of the second area 222 is smaller than or equal to the dimension of corresponding first area 221.

In other embodiments, each capacitive sensing element 3 is circularly shaped, each first area 221 is a circle, the diameter of the capacitive sensing element 3 is larger than or equal to the diameter of the corresponding first area 221.

The touch panel 1 includes a first surface 11 and a second surface 12 opposite to the first surface 11. Three capacitive sensing elements 3 contact with the second surface 12. Three labels 13 are located on the first surface 11 and respectively correspond to three capacitive sensing elements 3. In the embodiment, each label 13 may be a symbol showing a play/pause key, fast forward key, fast backward key, etc.

When a finger of the user contacts with one of labels 13, such as a play/pause key, an amount of electric charge of corresponding capacitive sensing element 3 is changed, an reproduction or stopping of reproduction of audio files is executed by external electronic device (not shown), such as a music player.

Because each first area 221 is not coated with copper, and each first area 221 corresponds to one of three capacitive sensing elements 3, the error operation of the prior art is effectively prevented. Additionally, in other embodiments, the bottom layer 22 is not coated with copper, the error operation of the prior art is also effectively prevented.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. A touch device comprising a touch panel, a circuit board, and at least one capacitive sensing element located between the touch panel and the circuit board; wherein the circuit board comprises a top layer and a bottom layer, each capacitive sensing element is mounted to the top layer, the bottom layer defines at least one first area, each first area corresponds to each capacitive sensing element, and each first area is not coated with copper.

2. The touch device of claim 1, wherein each second area is defined by a vertical projection of corresponding capacitive sensing element onto the bottom layer, the dimension of the second area is smaller than the dimension of corresponding first area.

3. The touch device of claim 1, wherein each second area is defined by a vertical projection of corresponding capacitive sensing element onto the bottom layer, the dimension of the second area is equal to the dimension of corresponding first area.

4. The touch device of claim 1, 2 or 3, wherein each capacitive sensing element is a copper sheet.

5. The touch device of any preceding claim, wherein each capacitive sensing element is circularly shaped, each first area is a circle, the diameter of the capacitive sensing element is larger than the diameter of the corresponding first area.

6. The touch device of any preceding claim, wherein the area of the top layer that is outside of at least one capacitive sensing element is not coated with copper.

7. The touch device of any preceding claim, wherein the touch panel comprises a first surface and a second surface opposite to the first surface, at least one label is located on the first surface, each capacitive sensing element contacts with the second surface, each label corresponds to each capacitive sensing element; when a finger of the user contacts with the label, an amount of electric charge of corresponding capacitive sensing element is changed.

8. The touch device of any preceding claim, wherein the circuit board is located below the touch panel.

9. The touch device of any preceding claim, wherein the number of at least one capacitive sensing element is three, and three capacitive sensing elements are arranged along the same line.

10. The touch device of claim 7, wherein the number of at least one label is three, and three labels are arranged along the same line.

11. The touch device of claim 7 or 10, wherein each label is a symbol showing one of a play/pause key, a fast forward key, and a fast backward key.

12. The touch device of any preceding claim, wherein the bottom layer is not coated with copper.

13. The touch device of any preceding claim, wherein each capacitive sensing element is circularly shaped, each first area is a circle, the diameter of the capacitive sensing element is equal to the diameter of the corresponding first area.
